Europäisches Patentamt

European Patent Office

Office européen des brevets

(19)

(11) EP 0 902 295 A2

(12) **EUROPÄISCHE PATENTANMELDUNG**

(43) Veröffentlichungstag:
17.03.1999 Patentblatt 1999/11

(51) Int Cl.⁶: **G01R 27/16**

(21) Anmeldenummer: 98810814.8

(22) Anmeldetag: 20.08.1998

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **09.09.1997 DE 19739379**

(71) Anmelder: **ABB Daimler-Benz Transportation (Technology) GmbH**
**13627 Berlin (DE)**

(72) Erfinder:
• **Mossig, Kai, Dr.**
**5400 Baden (CH)**
• **Terwiesch, Peter, Dr.**
**68535 Edingen-Neckarhausen (DE)**

(74) Vertreter: **Lück, Gert, Dr. et al**
**Asea Brown Boveri AG**
**Immaterialgüterrecht(TEI)**
**Haselstrasse 16/699 I**
**5401 Baden (CH)**

(54) **Verfahren zur Bestimmung der Belastbarkeit eines Wechselstromnetzes**

(57)   In leistungsschwachen Wechselstromnetzen ist es wünschenswert, beim Zuschalten einer Last L, z. B. eines Lichtbogenofens oder eines Fahrzeuges, die Ealastbarkeit des Wechselstromnetzes zu kennen, um unerwünschte Einbrüche einer Netzspannung $U_N$ zu vermeiden. Dazu werden nu einem vorgebbaren 1. Meßzeitpunkt und zu einem vorgebbaren späteren 2. Meßzeitpunkt zur Amplitude einer Lastspannung $U_L$ proportionale Lastspannungssignale am Ort der Last L detektiert. Gleichzeitig werden zur Amplitude eines Laststromes $I_L$ proportionale Laststromsignale detektiert. Ferner wird eine Phasendifferenz $\Delta\varphi$ bestimmt, welche sich mit Bezug auf die Phasenlage der Netzspannung $U_N$ im 1. Meßzeitpunkt ergibt. Auf Grund dieser Messungen wird ein Eetrag der Netzimpedanz des Wechselstromnetzes und ein Netzphasenwinkel $\varphi_N$ zwischen Netzspannung $U_N$ und Netzstrom berechnet. Eine maximal mögliche Leistung $P_L$ der Last L kann gemäß: $P_L = U_L^2 \cdot \cos \varphi_N / Z_N$ berechnet werden, $Z_N$ = Netzimpedanz.

FIG.2

**Beschreibung**

TECHNISCHES GEBIET

Bei der Erfindung wird ausgegangen von einem Verfahren zur Bestimmung der Belastbarkeit eines Wechselstromnetzes nach dem Oberbegriff des Patentanspruchs 1.

STAND DER TECHNIK

Mit dem Oberbegriff des Patentanspruchs 1 nimmt die Erfindung auf einen Stand der Technik Bezug, wie er aus der DE 4037531 Al bekannt ist. Dort ist ein Verfahren zur Steuerung von Gleichrichtern von Umrichtern für Drehstromtriebfahrzeuge beschrieben, bei dem die 4Quadrantensteller der Umrichter phasenverschoben getaktet werden. Dadurch werden Oberschwingungen, die beim Takten mehrerer Gleichrichter entstehen, in ihrer Summenwirkung auf das speisende Wechselstromnetz reduziert.

In leistungsschwachen Stromnetzen wird der Betrieb von elektrischen Bahnfahrzeugen häufig dadurch erschwert, daß Stabilitätsprobleme im Gesamtnetz durch eine Wechselwirkung von Fahrzeugen, Netzimpedanzen und Unterstationen auftreten. In solchen Stromnetzen bewirkt ein erhöhter Leistungsbezug eines Fahrzeugs sofort eine Amplituden- und Phasenänderung der Spannung bei den anderen Fahrzeugen. Derartige Probleme der Stabilität und Leistungsanpassung bei der Grundfrequenz von z. B. 16 2/3 Hz oder 50 Hz treten häufig in dünn besiedelten und industriell wenig entwickelten Ländern auf.

In der DE 195 04 271 C1 wird vorgeschlagen, die Impedanz eines Wechselstromnetzes dadurch zu messen, dass ein Blindstrom in das Netz eingespeist wird und die induzierte Phasenverschiebung gemessen wird.

Aus der DE 41 29 261 C1 ist ein Verfahren zur digitalen Stromregelung für einen Vierquadrantenregler in einem Wechselspannungsnetz bekannt. Dabei wird als Stromregelgrösse ein zukünftiger Stromwert verwendet, der unter Berücksichtigung eines Phasenwinkels der Netzspannung prognostiziert wird.

Die DE-AS 1 088 152 hat eine Einrichtung und ein Verfahren zur Ermittlung eines Netzinnenwiderstands zum Gegenstand. Es wird periodisch ein Netzbelastungswiderstand zugeschaltet und aus der Netzspannungsabsenkung der komplexe Netzinnenwiderstand bestimmt.

Zum einschlägigen Stand der Technik wird ferner auf das Buch von U. Tietze und Ch. Schenk, Halbleiter-Schaltungstechnik, 10. Auflage, Springer-Verlag 1993, S. 954 - 956, verwiesen, aus dem es bekannt ist, Phasenänderungen eines Schwingungssignals durch eine Nachlaufsynchronisition zu bestimmen. Von dieser Möglichkeit wird bei der vorliegenden Erfindung bezüglich der detektierten Netzspannung Gebrauch gemacht.

DARSTELLUNG DER ERFINDUNG

Die Erfindung, wie sie im Patentanspruch 1 definiert ist, löst die Aufgabe, ein Verfahren zur Bestimmung der Belastbarkeit eines Wechselstromnetzes der eingangs genannten Art derart weiterzuentwickeln, daß für eine gegebene variable Last die relevante wirksame Impedanz des Restsystems (andere Fahrzeuge, Leitungen, Unterstationen) bestimmt werden kann.

Vorteilhafte Ausgestaltungen der Erfindung sind in den abhängigen Patentansprüchen definiert.

Ein Vorteil der Erfindung besteht darin, daß anhand der Impedanz des Restsystems eingeschätzt werden kann, wie stark das Wechselstromnetz zusätzlich belastet werden kann. Dies ist anhand von Änderungsinformationen der Last möglich, wobei lediglich die Amplituden von Spannung, Strom und Änderung der Phasenlage zu erfassen sind.

Gemäß einer vorteilhaften Ausgestaltung der Erfindung kann die maximal mögliche Belastbarkeit des Wechselstromnetzes durch die Last bestimmt werden.

In Ländern, in denen ein ohmscher Betrieb mit einem Leistungsfaktor 1 fest vorgeschrieben ist, kann die erhaltene Information genutzt werden, um eine Instabilität und Überschreitung der maximal verfügbaren Leistung zu verhindern. In anderen Ländern, insbesondere solchen mit sehr langen Leitungen oder sehr schwachen Netzen, besteht der Wunsch, die Last, z. B. Fahrzeuge, im Nebennutzen als "rollende Phasenkompensatcren" zu nutzen. Die Leitungsinduktivitäten sollen dadurch kompensiert werden, daß z. B. das Fahrzeug, neben seinem Wirkleistungsbezug, als Stützkapazität wirkt. Bisher hat man, da die Netzimpedanz nicht zu schätzen war und sich durch eigenes und fremdes Fahren ständig ändert, in solchen Fällen mit fest eingestellten Phasenwinkeln gearbeitet, z. B. mit einem Leistungsfaktor von 0,8 kapazitiv. Je nach aktuellem Netzgeschehen ist dies zuviel oder zu wenig, so daß eine Anpassung an das Netz hier eine Verbesserung verspricht oder neue Märkte erschließen könnte, die heute wegen der schwachen Netze nicht handhabbar sind.

KURZE BESCHREIBUNG DER ZEICHNUNGEN

Die Erfindung wird nachstehend anhand von Ausführungsbeispielen erläutert. Es zeigen:

Fig. 1   ein Prinzipschaltbild eines Wechselstromnetzes mit mehreren daran angeschlossenen Lasten nach dem Stand der Technik,

Fig. 2   ein Prinzipschaltbild eines Wechselstromnetzes mit einer Last, an deren Ort die Netzimpedanz zu bestimmen ist und

Fig. 3   ein Spannungs-Zeit-Diagramm zu Fig. 2 zur Erläuterung der Erfindung.

WEGE ZUR AUSFÜHRUNG DER ERFINDUNG

In den Figuren sind gleiche Teile mit gleichen Bezugszeichen gekennzeichnet.

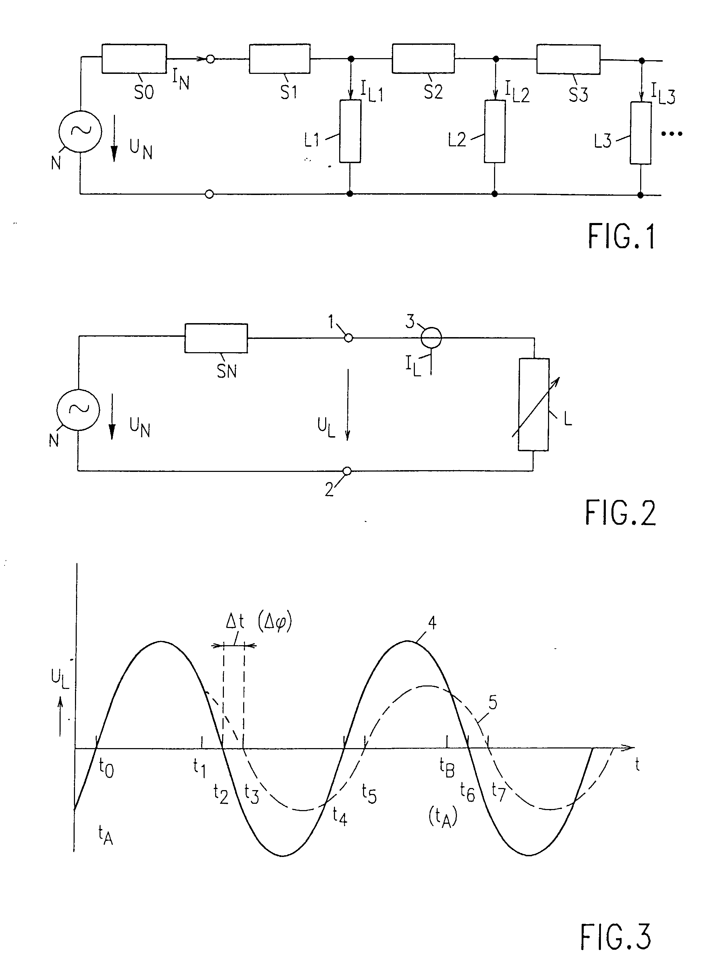

Fig. 1 zeigt ein Prinzipschaltbild eines Wechselstromnetzes mit einer Wechselspannungsquelle N, an welche Wechselstromlasten L1, L2, L3 angeschlossen sind und an der eine Wechselspannung bzw. eine Netzspannung ($U_N$) abgreifbar ist. S0 bezeichnet einen Wechselstromwiderstand der Wechselspannungsquelle N, S1 - S3 bezeichnet Leitungswiderstände bzw. Leitungsinduktivitäten, $I_N$ einen Wechselstrom der Wechselspannungsquelle (N) bzw. einen Netzstrom und $I_{L1}$ - $I_{L3}$ Wechselströme durch die Wechselstromlasten L1, L2, L3.

Beim Zuschalten weiterer, nicht dargestellter Lasten, z. B. von Lichtbogenöfen oder Asynchronmaschinen von Fahrzeugen, kann es vorkommen, daß die Wechselspannungsquelle N überlastet wird, was zu vermeiden ist. Um dies zu erkennen, muß die Belastbarkeit der Wechselspannungsquelle N bestimmt werden.

Fig. 2 zeigt eine variable Wechselstromlast L, die über einen Strommesser (3) an Netzanschlußstellen 1, 2 an ein von der Wechselspannungsquelle N gespeistes Wechselstromnetz angeschlossen ist, welches einen Wechselstromwiderstand bzw. Netzwiderstand SN aufweist, der von der Wechselstromlast L als Gesamtwiderstand des Wechselstromnetzes "gesehen" wird. Dieser Gesamtwiderstand kann mehrere Wechselstromlasten L1, L2, L3 gemäß Fig. 1 umfassen. An den Nezzanschlußstellen 1, 2 ist eine Wechselspannung bzw. Lastspannung $U_L$ abgreifbar und am Strommesser 3 ein Wechselstrom brw. Laststrom $I_L$. Die Wechselspannungsquelle (N) liefert eine Netzspannung $U_N$, deren Amplitude mit zunehmender Belastung abnehmen kann, mit einer vorgebbaren Frequenz von z. B. 16 2/3 Hz.

Fig. 3 zeigt in einer sinusförmigen, Signalkurve 4 den zeitlichen Signalverlauf einer Lastspannung $U_L$ an den Netzanschlußstellen 1, 2 ohne neue Last und in einer gestrichelt dargestellten Signalkurve 5 den zeitlichen Signalverlauf dieser Lastspannung $U_L$ mit einer neuen Last, welche zu einem Zeitpunkt tl an das Wechselstromnetz angeschlossen wird. Auf der Ordinate ist die Lastspannung $U_L$ und auf der Abszisse eine Zeit aufgetragen. Ohne neue Last zeigt die Lastspannung $U_L$ gemäß der Signal kurve 4 Spannungsnulldurchgänge zu Zeitpunkten t0, t2, t4, t6 usw. Durch das Zuschalten einer neuen Last verringert sich die Amplitude der Lastspannung $U_L$, gleichzeitig verschieben sich deren Nulldurchgänge gemäß der Signalkurve 5 zu Zeitpunkten t3, t5, t7 usw. Diese zeitliche Verschiebung bzw. Zeitdifferenz $\Delta t = t3 - t2 = t5 - t4 = t7 - t6$ wird mit einer eingangs erwähnten Nachlaufsynchronisation zwischen einem vorgebbaren 1. Meßzeitpunkt $t_A$ und einem vorgebbaren späteren 2. Meßzeitpunkt $t_B$ erfaßt; sie entspricht einer Phasenverschiebung bzw. Phasenänderung bzw. Phasendifferenz $\Delta\varphi$.

Zu dem 1. Meßzeitpunkt $t_A$ wird gleichzeitig eine 1. Lastspannung $U_{LA}$ und ein 1. Laststrom $I_{LA}$ gemessen. Zu dem 2. Meßzeitpunkt $t_B$ wird gleichzeitig eine 2. Lastspannung $U_{LB}$ und ein 2. Laststrom $I_{LB}$ gemessen. Die Zeitdifferenz $t_B - t_A$ wird im Bereich von 1 ms - 1 s gewählt, wobei ein kleinerer Wert günstiger, jedoch durch die Rechnergeschwindigkeit begrenzt ist. In diesem Zeitintervall kann sich die Wechselstromlast L um etwa 1 % - 20 ändern, was bei Fahrzeugen durch Bremsen oder Beschleunigen der Fall sein kann

Zur Bestimmung der Belastbarkeit des Wechselstromnetzes ist dessen Impedanz bzw. eine Netzimpedanz $\underline{Z}_N$ und ein Netzphasenwinkel ($\varphi_N$ zu ermitteln. Dabei werden vektorielle, komplexe Größen unterstrichen dargestellt. Die gleich bezeichneten, nicht unterstrichenen Größen bedeuten Amplituden.

Aus $\underline{U}_L = \underline{Z}_L \cdot \underline{I}_L$ und $\underline{U}_L = \underline{U}_N - \underline{Z}_N \cdot \underline{I}_L$ erhält man:

$$\underline{U}_N = (1 + \underline{Z}_N/\underline{Z}_L) \cdot \underline{U}_L,$$

wobei $\underline{Z}_L$ die Lastimpedanz bedeutet.

Unter der Annahme, daß sich zwischen dem 1. Meßzeitpunkt $t_A$ und dem 2. Meßzeitpunkt $t_B$ die Netzspannung $\underline{U}_N$ nicht nennenswert ändert, gilt $\underline{U}_{NA} = \underline{U}_{NB}$ und folglich:

$(1 + \underline{Z}_N/\underline{Z}_{LA}) \cdot \underline{U}_{LA} = (1 + \underline{Z}_N/\underline{Z}_{LB}) \underline{U}_{LB}$ und somit:

$$\underline{Z}_N = - (\underline{U}_{LA} - \underline{U}_{LB})/(\underline{I}_{LA} - \underline{I}_{LB}) \; .$$

In Polarkoordinatendarstellung erhält man die Gleichung:

$$\underline{Z}_N = - (U_{LA} \cdot e^{j\varphi_A} - U_{LB} \cdot e^{j\varphi_B})/(I_{LA} \cdot e^{j\varphi_A} - I_{LB} \cdot e^{j\varphi_B})$$

$$= - [U_{LA} - U_{LB} \cdot e^{j(\varphi_B - \varphi_A)}]/[I_{LA} - I_{LB} \cdot e^{j(\varphi_B - \varphi_A)}]$$

mit $\Delta\varphi = \varphi_B - \varphi_A$ .
Den Betrag der Netzimpedanz $\underline{Z}_N$ erhält man gemäß:

$$Z_N = |\underline{Z}_N| = \{[(U_{LA} - U_{LB} \cdot \cos \Delta\varphi)^2 + (U_{LB} \cdot \sin \Delta\varphi)^2]/$$

$$[(I_{LA} - I_{LB} \cdot \cos \Delta\varphi)^2 + (I_{LB} \cdot \sin \Delta\varphi)^2]\} \, 0{,}5$$

und den Netzphasenwinkel $\varphi N$ gemäß:

$$\varphi_N = \pi + \arctan [- (U_{LB} \cdot \sin \Delta\varphi)/(U_{LA} - U_{LB} \cdot \cos \Delta\varphi)]$$

$$- \arctan [- (I_{LB} \cdot \sin \Delta\varphi/(I_{LA} - I_{LB} \cdot \cos \Delta\varphi)].$$

Die in der Nechselstromlast L umpesetzte Wirkleistung $P_L$ ergibt sich gemäß:

$$P_L = \mathrm{Re} \, (\underline{U}_L \cdot \underline{I}_L{}^*) = \mathrm{Re} \, [\underline{U}_L \cdot U_L{}^*/Z_L{}^*] = U_L{}^2 \cdot R_L/|Z_L|^2,$$

wobei Re den Realteil, $R_L$ den ohmschen Anteil der Lastimpedanz $\underline{Z}_L$ und * die konjugiert komplexe Größe bedeuten.
Für eine Leistungsanpassung gilt:

$$\underline{Z}_L{}^* = \underline{Z}_N = Z_N \cdot \cos \varphi_N + j \cdot Z_N \cdot \sin \varphi_N.$$

Somit ergibt sich für die maximal mögliche Leistung der Wechselstromlast L: $P_L = U_L{}^2 \cdot \cos \varphi_N/Z_N$.
In rechtwinkligen Koordinaten erhält man folgende Formeln:

$$\underline{U}_{LA} = x_A + j \cdot y_A, \; \underline{U}_{LB} = x_B + j \cdot y_B,$$

$$\underline{I}_{LA} = p_A + j \cdot q_A, \; I_{LB} = p_B + j \cdot q_B,$$

$$\underline{Z}_N = v + j \cdot w$$

und daraus:

$$\underline{Z}_N = - [(x_A - x_B) + j \cdot (y_A - y_B)/(p_A - p_B) + j \cdot (q_A - q_B)]$$

mit dem Realteil $x_A - x_B = (p_A - p_B) \cdot v - (q_A - q_B) \cdot w$ und Imaginärteil $y_A - y_B = (q_A - q_B) \cdot v + (p_A - p_B) \cdot w$. Daraus erhält man:

$$v = - [(p_A - p_B) \cdot (x_A - x_B) + (q_A - q_B) \cdot (y_A - y_B)]/$$

$$[(p_A - p_B)^2 + (q_A - q_B)^2]$$

und

$$w = [(q_A - q_B) \cdot (x_A - x_B) - (p_A - p_B) \cdot (y_A - y_B)]/$$

$$[(p_A - p_B)^2 + (q_A - q_B)^2]$$

Es gilt: $Z_N = (v^2 + w^2)^{0,5}$ und $\varphi_N = \arctan(w/v)$.

Diese Darstellung in rechtwinkligen Koordinaten eignet sich besser für eine praktische Anwendung als die Darstellung in Polarkoordinaten.

Nach der Erfassung des 2. Meßeitpunktes $t_B$ kann dieser als 1. Meßzeitpunkt $t_A$ für die nächstfolgende Messung dienen. Spannungen und Ströme können auch an einem Gleichspannungszwischenkreis eines nicht dargestellten Umrichters zur Speisung von Maschinen als Gleichspannung und Gleichstrom detektiert werden. Wichtig ist, daß die Spannungen und Ströme zu zwei unterschiedlichen Zeitpunkten erfaßt werden und daß in diesem Zeitintervall die Phasendifferenz $\Delta\varphi$ eines zur Netzspannung $U_N$ proportionalen Frequenzsignals erfaßt wird.

Bei einer Verwendung für Fahrzeuge kann mit der vorliegenden Erfindung

-   die maximal verfügbare Leistung für jedes Fahrzeug,
-   die minimale Gesamtleistung und
-   die größtmögliche Stabilität des Wechselstromnetzes unter allen Bedingungen ermittelt werden.

Das strategische Ziel für jedes Fahrzeug sollte es sein:

-   die Lastimpedanz $\underline{Z}_L$ an diejenige des Wechselstromnetzes anzupassen und
-   die maximal mögliche Leistung $P_L$ der Wechselstromlast L nicht zu überschreiten.

BEZEICHNUNGSLISTE

| | |
|---|---|
| 1, 2 | Netzanschlußstellen von L |
| 3 | Strommesser |
| 4 | Signalkurve, Signalverlauf einer Lastspannung $U_L$ ohne neue Last |
| 5 | Signalkurve, Signalverlauf der Lastspannung $U_L$ mit neuer Last |
| $I_N$ | Wechselstrom eines Wechselstromnetzes, Netzstrom |
| $I_L$ | Laststrom, Wechselstrom, durch L |
| $I_{L1} - I_{L3}$ | Wechselströme durch die Lasten L1 - L3, Lastströme |
| L, L1 - L3 | Wechselstromlasten, Maschinen, Lichtbogenöfen |
| N | Wechselspannungsquelle |
| S0 | Wechselstromwiderstand von N |
| S1, S2, S3 | Leitungsinduktivitäten |
| SN | Nechselstromwiderstand des Wechselstromnetzes, Netzwiderstand an 1, |
| t | Zeit |
| t1 - t7 | Zeitpunkte |
| $t_A$ | 1. Meßzeitpunkt |
| $t_B$ | 2. Meßzeitpunkt |
| $\Delta t$ | Zeitdifferenz |
| $U_L$ | Wechselspannung an L, Lastspannung |
| $U_N$ | Wechselspannung von N, Netzspannung |
| $\Delta\varphi$ | Phasenänderung, Phasendifferenz |

**Patentansprüche**

1.  Verfahren zur Bestimmung der Belastbarkeit eines Wechselstromnetzes am Ort einer elektrischen Last (L),

a) welche aus dem Mechselstromnetz gespeist wird,

dadurch gekennzeichnet,

b) daß zu einem vorgebbaren 1. Meßzeitpunkt $t_A$ und

c) zu einem vorgebbaren späteren 2. Meßzeitpunkt $t_B$

d) zur Amplitude einer Lastspannung ($U_L$) proportionale Lastspannungssignale $U_{LA}$ und $U_{LB}$ detektiert werden,

e) daß gleichzeitig ferner zur Amplitude eines Laststromes ($I_L$) proportionale Laststromsignale $I_{LA}$ und $I_{LB}$ detektiert werden, wobei sich die Indices A bzw. B auf eine Detektion im 1. Meßzeitpunkt $t_A$ bzw. im 2. Meßzeitpunkt $t_B$ beziehen,

f) daß zu dem 2. Meßzeitpunkt $t_B$ von einem zur Netzspannung ($U_N$) proportionalen Signal eine Phasendifferenz $\Delta\varphi$ detektiert wird, welche sich mit Bezug auf die Phasenlage der Netzspannung ($U_N$) im 1. Meßzeitpunkt $t_A$ ergibt,

g) daß ein Betrag der Netzimpedanz $\underline{Z}_N$ des Wechselstromnettes wenigstens annähernd gemäß:

$$\left|\underline{Z}_N\right| = \{[(U_{LA} - U_{LB} \cdot \cos \Delta\varphi)^2 + (U_{LB} \cdot \sin \Delta\varphi)^2]/$$

$$[(I_{LA} - I_{LB} \cdot \cos \Delta\varphi)^2 + (I_{LB} \cdot \sin \Delta\varphi)^2]\}0,5$$

oder

h)

$$\left|\underline{Z}_N\right| = I \cdot [(x_A - x_B) + j \cdot (y_A - y_B)/$$

$$(p_A - p_B + j \cdot (q_A - q_B)]I$$

gebildet wird und

i) daß ein Netzphasenwinkel $\varphi_N$ zwischen Netzspannung ($U_N$) und Netzstrom ($I_N$) wenigstens annähernd gemäß:

$$\varphi_N = \pi + \arctan [- (U_{LB} \cdot \sin \Delta\varphi)/(U_{LA} - U_{LB} \cdot \cos \Delta\varphi)]$$

$$- \arctan [- (I_{LB} \cdot \sin \Delta\varphi)/(I_{LA} - I_{LB} \cdot \cos \Delta\varphi)]$$

oder

j)

$$\varphi_N = \arctan (w/v$$

gebildet wird, mit

$$v = - [(p_A - p_B) \cdot (x_A - x_B) + (q_A - q_B) \cdot (y_A - y_B)]/$$

$$[(p_A - p_B)^2 + (q_A - q_B)^2],$$

$$w = [(q_A - q_B) \cdot (x_A - x_B) - (p_A - p_B) \cdot (y_A - y_B)]/$$

$$[(p_A - p_B)^2 + (q_A - q_B)^2],$$

$$\underline{U}_{LA} = x_A + j \cdot y_A,$$

$$\underline{U}_{LB} = x_B + j \cdot y_B, \underline{I}_{LA} = p_A + j \cdot q_A$$

und

$$\underline{I}_{LB} = p_B + j \cdot q_B.$$

2. Verfahren nach Anspruch 1, dadurch gekennzeichnet, daß eine maximal mögliche Leistung $P_L$ der Last (L) gemäß:

$$P_L = U_L^{\ 2} \cdot \cos \varphi_N / Z_N$$

gebildet wird.

3. Verfahren nach Anspruch 1 oder 2, dadurch gekennzeichnet, a) daß die Last spannung ($U_L$) eine Wechselspannung und b) daß der Laststrom ($I_L$) ein Wechselstrom sind.

4. Verfahren nach einem der vorhergehenden Ansprüche, dadurch gekennzeichnet, daß die Last (L) mindestens eine Maschine eines Fahrzeuges umfaßt.

FIG.1

FIG.2

FIG.3